# EUROPEAN PATENT APPLICATION

(11) **EP 4 596 751 A1**
(43) Date of publication of application: **06.08.2025**
(21) Application number: 24222787.4
(22) Date of filing: 23.12.2024
(51) Int. Cl.: C23C 16/455, C23C 16/04, C23C 16/34

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 25.12.2023 JP 2023218185
(71) Applicant: Kokusai Electric Corporation, Tokyo 101-0045 (JP)
(72) Inventor: NOHARA, Shingo, Toyama-shi, Toyama 939-2393 (JP); ISHIBASHI, Kiyohisa, Toyama-shi, Toyama 939-2393 (JP); YAMANE, Yoma, Toyama-shi, Toyama 939-2393 (JP)
(74) Representative: Bardehle Pagenberg Partnerschaft mbB Patentanwälte Rechtsanwälte

(57) **Abstract**

There is provided a technique that includes: forming a film on the substrate by performing a first cycle a predetermined number of times, the first cycle including performing: (a) supplying a first processing gas to the substrate; and (b) supplying a second processing gas to the substrate, wherein (a) includes sequentially performing: (a-1) opening a first storage filled with the first processing gas and supplying the first processing gas discharged from the first storage to the substrate via a first supply port; (a-2) exhausting a processing space in which the substrate is processed while stopping the supply of the first processing gas to the substrate; and (a-3) opening a second storage filled with the first processing gas and supplying the first processing gas discharged from the second storage to the substrate via a second supply port different from the first supply port.

## Description

### CROSS-REFERENCE TO RELATED APPLICATION

This application is based upon and claims the benefit of priority from Japanese Patent Application No. 2023-218185, filed on December 25, 2023, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a substrate processing process (a process of manufacturing a semiconductor device), a process of forming a film on a substrate is performed.

### SUMMARY

Some embodiments of the present disclosure provide a technique capable of improving a step coverage of a film formed on a substrate.

According to some embodiments of the present disclosure, there is provided a technique that includes: forming a film on the substrate by performing a first cycle a predetermined number of times, the first cycle including performing: (a) supplying a first processing gas to the substrate; and (b) supplying a second processing gas to the substrate, wherein (a) includes sequentially performing: (a-1) opening a first storage filled with the first processing gas and supplying the first processing gas discharged from the first storage to the substrate via a first supply port; (a-2) exhausting a processing space in which the substrate is processed while stopping the supply of the first processing gas to the substrate; and (a-3) opening a second storage filled with the first processing gas and supplying the first processing gas discharged from the second storage to the substrate via a second supply port different from the first supply port.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in some embodiments of the present disclosure, in which a portion of a process furnace is illustrated in a vertical cross-sectional view.
FIG. 2 is a schematic configuration diagram of the vertical process furnace of the substrate processing apparatus suitably used in some embodiments of the present disclosure, in which a portion of the process furnace is illustrated in a cross-sectional view taken along line A-A in FIG. 1.
FIG. 3 is a schematic configuration diagram of a controller of a substrate processing apparatus used suitably used in some embodiments of the present disclosure, in which a control system of the controller is illustrated in a block diagram.
FIG. 4 is a diagram showing a processing sequence in some embodiments of the present disclosure, and a diagram showing supply timings of a first processing gas, a second processing gas, and an inert gas, and transition of open/closed states of an APC valve.
FIG. 5 is a diagram showing an excerpt of processing sequences in steps A and B in a first modification of the present disclosure.
FIG. 6 is a diagram showing a processing sequence in a second modification of the present disclosure.
FIG. 7 is a diagram showing an excerpt of processing sequences in steps A and B in a third modification of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of Present Disclosure>

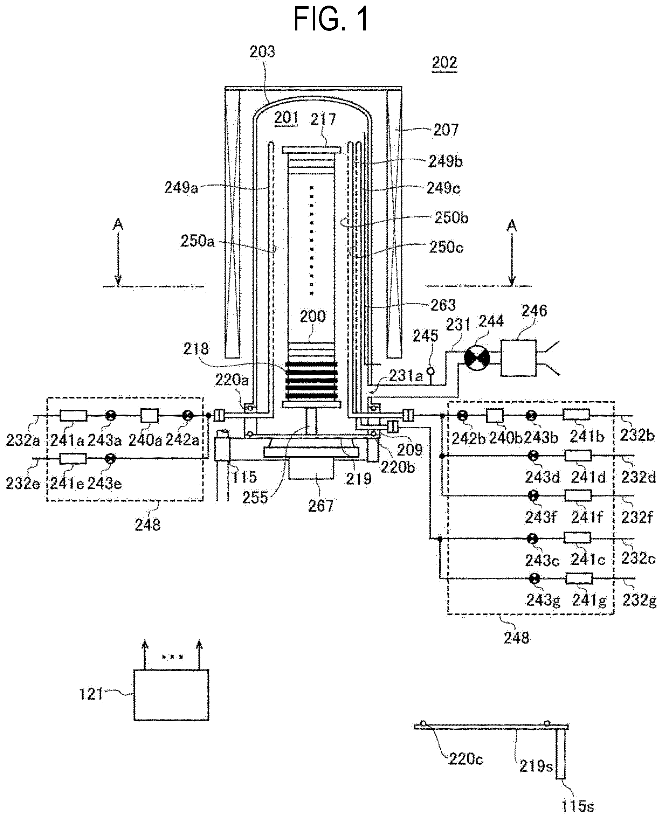

Hereinafter, some embodiments of the present disclosure will be described mainly with reference to FIGS. 1 to 4. Further, drawings used in the following description are schematic, and dimensional relationships, ratios, and the like among various components shown in the drawings may not match actual ones. Further, dimensional relationship, ratios, and the like of various components among a plurality of drawings may not match one another

### (1) Configuration of Substrate Processing Apparatus

As shown in FIG. 1, a process furnace 202 includes a heater 207 as a temperature regulator (a heating part). The heater 207 is formed in a cylindrical shape and is vertically installed by being supported by a holding plate. The heater 207 functions as an activator (an exciter) configured to activate (excite) a gas with heat.

A reaction tube 203 is disposed inside the heater 207 to be concentric with the heater 207. The reaction tube 203 is made of, for example, heat resistant material such as quartz (SiO₂) or silicon carbide (SiC), and is formed in a cylindrical shape with its upper end closed and its lower end opened. A manifold 209 is disposed to be concentric with the reaction tube 203 under the reaction tube 203. An upper end of the manifold 209 engages with the lower end of the reaction tube 203 to support the reaction tube 203. An O-ring 220a serving as a seal is installed between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical area of the process container. The process chamber 201 is configured to be capable of accommodating wafers 200 as substrates. The wafers 200 are processed in the process chamber 201.

Nozzles 249a to 249c as first to third suppliers are respectively installed in the process chamber 201 to penetrate through a sidewall of the manifold 209. The nozzles 249a to 249c are also referred to as first to third nozzles, respectively. The nozzles 249a to 249c are made of, for example, heat resistant material such as quartz or SiC. Gas supply pipes 232a to 232c as first to third pipes are connected to the nozzles 249a to 249c, respectively. The nozzles 249a to 249c are different nozzles.

At the gas supply pipe 232a as the first pipe and the gas supply pipe 232b as the second pipe, mass flow controllers (MFCs) 241a and 241b as flow rate controllers (flow rate control parts), valves 243a and 243b as opening/closing valves, a first storage 240a and a second storage 240b configured to be capable of temporarily storing a gas, and valves 242a and 242b are installed sequentially from the upstream side of a gas flow. The first storage 240a and gas supply holes 250a as a first supply port are connected via the gas supply pipe 232a as the first pipe, and the second storage 240b and gas supply holes 250b as a second supply port are connected via the gas supply pipe 232b as the second pipe which is independent from the gas supply pipe 232a without any common section. A gas supply pipe 232e is connected to the gas supply pipe 232a at the downstream side of the valve 242a. Gas supply pipes 232d and 232f are connected to the gas supply pipe 232b at the downstream side of the valve 242b. At the gas supply pipes 232d to 232f, MFCs 241d to 241f and valves 243d to 243f are provided sequentially from the upstream side of a gas flow.

Each of the first storage 240a and the second storage 240b is configured as, for example, a gas tank with a larger gas capacity than a typical pipe, a pipe with a larger diameter than a typical pipe, or a spiral pipe. By opening or closing the valves 243a and 243b at the upstream side of the first storage 240a and the second storage 240b and the valves 242a and 242b at the downstream side of the first storage 240a and the second storage 240b, respectively, the first storage 240a and the second storage 240b may be filled with gases supplied from the gas supply pipes 232a and 232b respectively, and the gas filled in the first storage 240a and the second storage 240b may be supplied into the process chamber 201. A conductance between the first storage 240a and the process chamber 201 may be set to be, for example, 1.5×10⁻³ m³/s or more. Further, considering a ratio between a volume of the process chamber 201 and a volume of the first storage 240a, when the volume of the process chamber 201 is 100 L (liters), the volume of the first storage 240a may be, for example, 100 to 3000 cc, and may be, for example, 1/1000 to 30/1000 times the volume of the process chamber 201. The same applies to the second storage 240b.

By closing the valves 242a and 242b and opening the valves 243a and 243b, the gases whose flow rates are regulated by the MFCs 241a and 241b may be filled into the first storage 240a and the second storage 240b, respectively. When predetermined amounts of gases are filled into the first storage 240a and the second storage 240b respectively, and pressures in the first storage 240a and the second storage 240b reach predetermined pressures respectively, the valves 243a and 243b are closed and the valves 242a and 242b are opened, whereby that high-pressure gases filled into the first storage 240a and the second storage 240b may be supplied (flush-supplied) into the process chamber 201 at once in a short time via the gas supply pipes 232a and 232b and the nozzles 249a and 249b. Further, during the flush supply, the valves 243a and 243b may be open.

At the gas supply pipe 232c, a MFC 241c and a valve 243c as an opening/closing valve are installed sequentially from the upstream side of a gas flow. A gas supply pipe 232g is connected to the gas supply pipe 232c at the downstream of the valve 243c. At the gas supply pipe 232g, a MFC 241g and a valve 243g are installed sequentially from the upstream side of a gas flow.

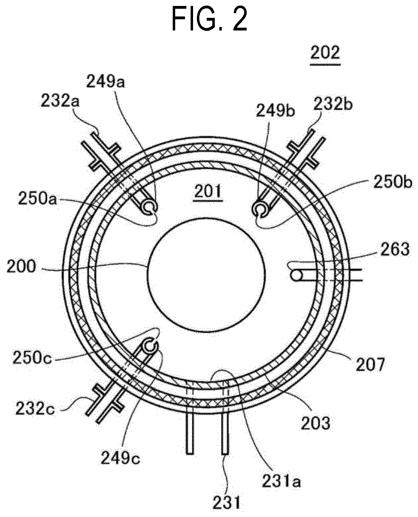

As shown in FIG. 2, the nozzles 249a to 249c are respectively installed in an annular space (in a plane view) between an inner wall of the reaction tube 203 and the wafers 200 to extend upward from a lower side to an upper side of the inner wall of the reaction tube 203, that is, along an arrangement direction of the wafers 200. Specifically, the nozzles 249a to 249c are respectively installed in a region horizontally surrounding a wafer arrangement region in which the wafers 200 are arranged at a lateral side of the wafer arrangement region, along the wafer arrangement region.

The nozzle 249c is disposed closer to the exhaust port 231a, which will be described later, than the nozzles 249a and 249b. That is, the nozzles 249a and 249b are disposed farther from the exhaust port 231a than the nozzle 249c. Further, the nozzles 249a and 249b are disposed symmetrically with respect to the centers of the wafers 200 in a state where the wafers 200 are loaded into the process chamber 201, i.e., a line passing through a center of the reaction tube 203 and a center of the exhaust port 231a, as an axis of symmetry, in a plane view. Further, the nozzle 249b and the nozzle 249c are disposed to face each other on a straight line with the center of the reaction tube 203 interposed therebetween. That is, the nozzle 249b is disposed to face the nozzle 249c.

Gas supply holes 250a to 250c are respectively formed, at side surfaces of the nozzles 249a to 249c, as first to third supply ports configured to supply gases from the outer peripheries of the wafers 200 toward the planes of the wafers 200. The gas supply holes 250a as the first supply port and the gas supply holes 250c as the third supply port are respectively opened to face the center or the vicinity of the center of the reaction tube 203, and are configured to be capable of supplying gases toward the wafers 200. The gas supply holes 250b as the second supply port are configured to supply gases in a direction different from the direction facing the centers of the wafers 200, more specifically, in a direction facing outer edge sides of the wafers 200 rather than the direction facing the centers of the wafers 200. The gas supply holes 250a to 250c are formed from the lower side to the upper side of the reaction tube 203.

The nozzle 249a and the nozzle 249b may be disposed closer to each other across a straight line passing through the center of the reaction tube 203 and the center of the exhaust port 231a. Further, the gas supply holes 250a and the gas supply holes 250b may be respectively opened to be capable of supplying gases in a direction parallel to the straight line passing through the center of the reaction tube 203 and the center of the exhaust port 231a.

Further, the gas supply holes 250a to 250c are not limited to being constituted by circular or elliptical openings, and may be constituted by openings formed in other shapes, such as slit-shaped openings formed to extend in a direction perpendicular to an extension direction of the nozzles 249a to 249c (i.e., in the plane direction of the wafer 200). Further, the gas supply holes 250a to 250c may be constituted by one or more slit-shaped openings formed along the extension direction of the nozzles 249a to 249c, respectively.

A first processing gas as a precursor gas is supplied from the gas supply pipe 232a into the process chamber 201 via the MFC 241a, the valve 243a, the first storage 240a, the valve 242a, and the nozzle 249a.

A first processing gas as a precursor gas is supplied from the gas supply pipe 232b into the process chamber 201 via the MFC 241b, the valve 243b, the second storage 240b, the valve 242b, and the nozzle 249b.

A second processing gas as a reaction gas is supplied from the gas supply pipe 232c into the process chamber 201 via the MFC 241c, the valve 243c, and the nozzle 249c.

A modifying gas is supplied from the gas supply pipe 232d into the process chamber 201 via the MFC 241d, the valve 243d, and the nozzle 249d.

An inert gas is supplied from the gas supply pipes 232e to 232g into the process chamber 201 via the MFCs 241e to 241g, the valves 243e to 243g, the gas supply pipes 232a to 232c, and the nozzles 249a to 249c, respectively. The inert gas acts as a purge gas, a carrier gas, a dilution gas, or the like.

A first gas supply system (first processing gas supply system) mainly includes the gas supply pipe 232a, the MFC 241a, the valves 243a and 242a, and the first storage 240a. A second gas supply system (second processing gas supply system) mainly includes the gas supply pipe 232b, the MFC 241b, the valves 243b and 242b, and the second storage 240b. A third gas supply system (third processing gas supply system) mainly includes the gas supply pipe 232c, the MFC 241c, and the valve 243c. A fourth gas supply system (modifying gas supply system) mainly includes the gas supply pipe 232d, the MFC 241d, and the valve 243d. An inert gas supply system mainly includes the gas supply pipes 232e to 232g, the MFCs 241e to 241g, and the valves 243e to 243g. Further, the nozzles connected to the gas supply pipes constituting the various supply systems described above may also be included in the supply systems respectively.

The exhaust port 231a configured to exhaust an internal atmosphere of the process chamber 201 is installed at the lower side of the sidewall of the reaction tube 203. As shown in FIG. 2, the exhaust port 231a is installed at a position opposing (facing) the nozzles 249a to 249c (the gas supply holes 250a to 250c) with the wafers 200 interposed therebetween in the plane view. The exhaust port 231a may be installed to extend from the lower side to the upper side of the sidewall of the reaction tube 203, that is, along the wafer arrangement region. An exhaust pipe 231 as an exhaust path is connected to the exhaust port 231a. A vacuum pump 246 as a vacuum exhauster is connected to the exhaust pipe 231 via a pressure sensor 245, which is a pressure detector (pressure detection part) configured to detect an internal pressure of the process chamber 201, and an auto pressure controller (APC) valve 244, which is a pressure regulator (pressure regulation part). The APC valve 244 as an exhaust valve is configured to be capable of performing or stopping vacuum exhausting operation of an inside of the process chamber 201 by being opened or closed while the vacuum pump 246 is actuated, and is also configured to be capable of regulating the internal pressure of the process chamber 201 by adjusting a degree of valve opening based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219 as a furnace opening lid configured to be capable of airtightly closing a lower end opening of the manifold 209 is installed below the manifold 209. An O-ring 220b as a seal, which comes into contact with the lower end of the manifold 209, is installed on an upper surface of the seal cap 219. A rotator 267 configured to rotate a boat 217 to be described below is installed below the seal cap 219. A rotary shaft 255 of the rotator 267 is connected to the boat 217 through the seal cap 219. The rotator 267 is configured to rotate the wafers 200 by rotating the boat 217. The seal cap 219 is configured to be vertically moved up or down by a boat elevator 115 which is an elevator installed outside the reaction tube 203. The boat elevator 115 is constituted as a transfer apparatus (transfer mechanism) configured to load or unload (transfers) the wafers 200 into or out of the process chamber 201 by moving the seal cap 219 up or down.

Below the manifold 209, a shutter 219s is installed as a furnace opening lid configured to be capable of airtightly closing the lower end opening of the manifold 209 while the seal cap 219 is lowered and the boat 217 is unloaded from the process chamber 201. An O-ring 220c as a seal, which comes into contact with the lower end of the manifold 209, is installed on an upper surface of the shutter 219s. The opening/closing operation (such as elevation operation, rotation operation, or the like) of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, heat resistant material such as quartz or SiC. Heat insulating plates 218 are installed in multiple stages at the bottom of the boat 217.

A temperature sensor 263 serving as a temperature detector is installed in the reaction tube 203. Based on temperature information detected by the temperature sensor 263, a state of supplying electric power to the heater 207 is regulated such that a temperature distribution in the process chamber 201 becomes a desired temperature distribution. The temperature sensor 263 is installed along the inner wall of the reaction tube 203.

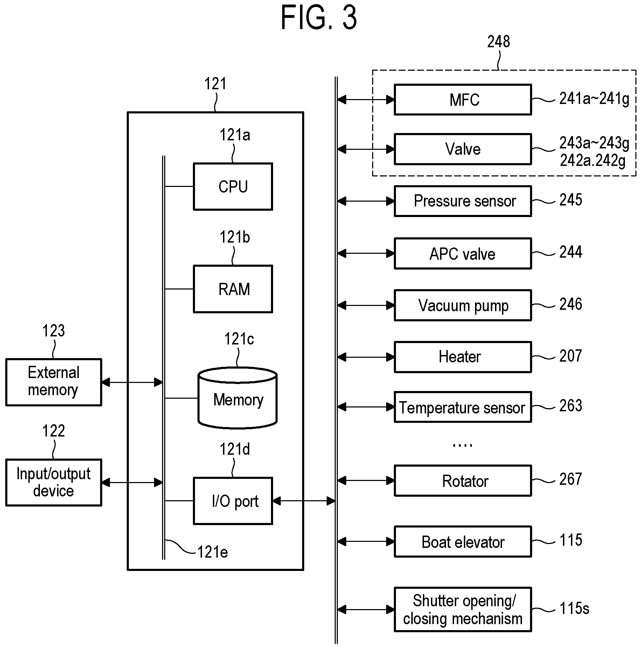

As shown in FIG. 3, the controller 121 as a control part (control means or unit) is constituted as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 constituted as, for example, a touch panel or the like is connected to the controller 121. Further, an external memory 123 may be connected to the controller 121. Further, the substrate processing apparatus may be configured to include one controller or a plurality of controllers. That is, a control to perform a processing sequence to be described below may be performed by using one controller or a plurality of controllers. Further, the plurality of controllers may be constituted as a control system in which the controllers are connected to each other via a wired or wireless communication network, and the control to perform the processing sequence to be described below may be performed by the entire control system. When the term "controller" is used herein, it may indicate a case of including a controller, a case of including a plurality of controllers, or a case of including a control system constituted by a plurality of controllers.

The memory 121c includes, for example, a flash memory, a hard disk drive (HDD), a solid state drive (SSD), or the like. A control program that controls operations of a substrate processing apparatus, a process recipe in which sequences and conditions of substrate processing to be described below are written, and the like are readably recorded and stored in the memory 121c. The process recipe functions as a program that causes, by the controller 121, the substrate processing apparatus to perform each sequence in the substrate processing (film-forming processing) to be described below to obtain an expected result. Hereinafter, the process recipe and the control program may be generally and simply referred to as a "program." Further, the process recipe may be simply referred to as a "recipe." When the term "program" is used herein, it may indicate a case of including the recipe, a case of including the control program, or a case of including both the recipe and the control program. The RAM 121b is constituted as a memory area (work area) in which programs or data read by the CPU 121a are temporarily stored.

The I/O port 121d is connected to the MFCs 241a to 241g, the valves 243a to 243g, 242a and 242b, the pressure sensor 245, the APC valve 244, the vacuum pump 246, the temperature sensor 263, the heater 207, the rotator 267, the boat elevator 115, the shutter opening/closing mechanism 115s, and the like.

The CPU 121a is configured to be capable of reading and executing the control program from the memory 121c. The CPU 121a is also configured to be capable of reading the recipe from the memory 121c according to an input of an operation command from the input/output device 122, or the like. The CPU 121a is configured to be capable of controlling the flow rate regulating operation of various kinds of materials (gases) by the MFCs 241a to 241h, the opening/closing operation of the valves 243a to 243g, 242a, and 242b, the opening/closing operation of the APC valve 244, the pressure regulating operation performed by the APC valve 244 based on the pressure sensor 245, the actuating and stopping operation of the vacuum pump 246, the temperature regulating operation performed by the heater 207 based on the temperature sensor 263, the operation of rotating the boat 217 and adjusting the rotation speed of the boat 217 with the rotator 267, the operation of moving the boat 217 up or down by the boat elevator 115, the opening/closing operation of the shutter 219s by the shutter opening/closing mechanism 115s, and so on, according to contents of the read recipe.

The controller 121 may be constituted by installing, in the computer, the above-described program recorded and stored in the external memory 123. Examples of the external memory 123 may include a magnetic disc such as a HDD, an optical disc such as a CD, a magneto-optical disc such as a MO, a semiconductor memory such as a USB memory or a SSD, and the like. The memory 121c or the external memory 123 is constituted as a computer-readable recording medium. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. Further, the program may be provided to the computer by using communication means or unit such as the Internet or a dedicated line, instead of using the external memory 123.

### (2) Substrate Processing Process

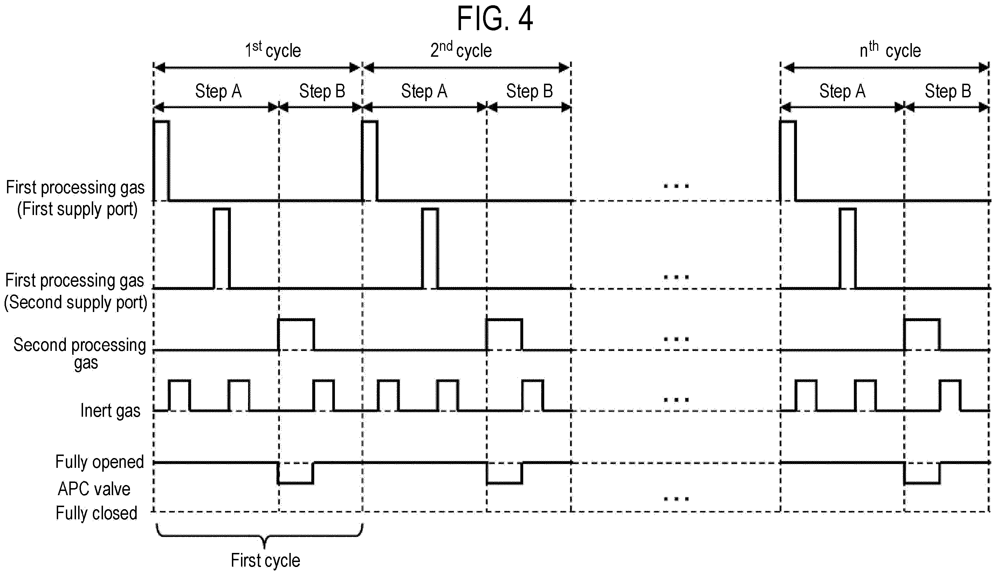

A sequence example of a method of processing a substrate as a process of manufacturing a semiconductor device by using the above-described substrate processing apparatus, i.e., an example of a processing sequence of forming a film on the wafer 200 as a substrate with a surface on which recesses such as trenches or grooves, holes and the like with a three-dimensional structure are formed, will be described mainly with reference to FIG. 4. In the following description, operations of the respective components constituting the substrate processing apparatus are controlled by the controller 121.

A processing sequence according to the embodiments of the present disclosure includes:
forming a film on a wafer 200 by performing a first cycle a predetermined number of times (n times where n is an integer of 1 or 2 or more), the first cycle including non-simultaneously performing:
   (a) step A of supplying a first processing gas to the wafer 200; and
   (b) step B of supplying a second processing gas to the wafer 200,
wherein step A includes sequentially performing:
   (a-1) step a1 of opening the first storage 240a filled with the first processing gas and supplying the first processing gas discharged from the first storage 240a to the wafer 200 via the gas supply holes 250a;
   (a-2) step a2 of exhausting the processing space in which the wafer 200 is processed while stopping the supply of the first processing gas to the wafer 200; and
   (a-3) step a3 of opening the second storage 240b filled with the first processing gas and supplying the first processing gas discharged from the second storage 240b to the wafer 200 via the gas supply holes 250b different from the gas supply holes 250a.

Further, in the embodiments of the present disclosure, as shown in FIG. 4, an inside of the process chamber 201 may be exhausted after the supply of the first processing gas in step A and after the supply of the second processing gas in step B, respectively. A case where the exhaust is performed will be described below.

In the present disclosure, for the sake of convenience, the processing sequence described above may also be denoted as follows. The same notation is also used in the following description of modifications and other embodiments. f (first processing gas → exhaust → first processing gas → exhaust) → (second processing gas -> exhaust)} × n

The term "wafer" used herein may refer to a wafer itself or a stacked body of a wafer and a predetermined layer or film formed on a surface of the wafer. The phrase "a surface of a wafer" used herein may refer to a surface of a wafer itself or a surface of a predetermined layer or the like formed on a wafer. The expression "a predetermined layer is formed on a wafer" used herein may mean that a predetermined layer is directly formed on a surface of a wafer itself or that a predetermined layer is formed on a layer or the like formed on a wafer. The term "substrate" used herein may be synonymous with the term "wafer."

As used herein, the term "layer" includes at least one selected from the group of a continuous layer and a discontinuous layer. For example, first to third layers to be described below may include a continuous layer, a discontinuous layer, or both.

In the present disclosure, when describing about the first processing gas and the second processing gas are described as respectively being adsorbed on or reacting with the surface of the wafer 200, it may include a case where the first processing gas and the second processing gas are adsorbed on or react with the surface of the wafer 200 while remaining undecomposed, and a case where the first processing gas and the second processing gas are decomposed or intermediates generated by desorption of their ligands are adsorbed on or react with the surface of the wafer 200.

### (Wafer Charging and Boat Loading)

After the boat 217 is charged with a plurality of wafers 200 (wafer charging), the shutter 219s is moved by the shutter opening/closing mechanism 115s and the lower end opening of the manifold 209 is opened (shutter opening). Thereafter, as shown in FIG. 1, the boat 217 supporting the plurality of wafers 200 is lifted by the boat elevator 115 and loaded into the process chamber 201 (boat loading). In this state, the seal cap 219 seals the lower end of the manifold 209 via the O-ring 220b.

### (Pressure Regulation and Temperature Adjustment)

After the boat loading is completed, the inside of the process chamber 201, that is, a processing space which is a space where the wafers 200 are placed, is vacuum-exhausted (decompression-exhausted) by the vacuum pump 246 to reach a desired pressure (a state of vacuum). In this operation, the internal pressure of the process chamber 201 is measured by the pressure sensor 245, and the APC valve 244 is feedback-controlled based on the measured pressure information (pressure regulation). Further, the wafers 200 in the process chamber 201 are heated by the heater 207 to reach a desired processing temperature. In this operation, a state of supplying electric power to the heater 207 is feedback-controlled based on the temperature information detected by the temperature sensor 263 such that a temperature distribution in the process chamber 201 becomes a desired temperature distribution (temperature regulation). Further, the rotation of the wafers 200 by the rotator 267 is started. The exhaust of the inside of the process chamber 201 and the heating and rotation of the wafers 200 may be continuously performed at least until the processing on the wafers 200 is completed.

### (Film Formation Process)

Then, the following steps A and B are performed in sequence.

### [Step A]

In this step, step a1 of supplying a first processing gas to the wafer 200 accommodated in the process chamber 201, step a2 of exhausting the inside of the process chamber 201, and step a3 of supplying the first processing gas to the wafer 200 accommodated in the process chamber 201 are sequentially performed. As used herein, the term "exhaust" refers to performing at least one selected from the group of purging and vacuum exhaust. In the embodiments of the present disclosure, as an example, a case where purging and vacuum exhaust are sequentially performed when exhausting the inside of the process chamber 201 will be described.

Before step a1 is performed, the valve 242a is closed, and the valve 243a is opened to allow the first processing gas to flow through the gas supply pipe 232a. A flow rate of the first processing gas is regulated by the MFC 241a. The first processing gas is supplied into the first storage 240a. As a result, the first storage 240a is filled with the first processing gas at a pressure increased to a filling pressure. When the first storage 240a is filled with a predetermined amount of the first processing gas, the valve 243a is closed to maintain the state in which the first storage 240a is filled with the first processing gas.

### (i) Step a1

In this step, a first processing gas is supplied to the wafer 200 accommodated in the process chamber 201.

Specifically, the valve 242a is opened to allow the high-pressure first processing gas filled in the first storage 240a to flow through the decompressed process chamber 201 at a time. This causes the first processing gas to be supplied to the wafer 200 at a time (first flush supply of the first processing gas). At this time, the valve 243a is kept opened. At this time, the valves 243e to 243g may be opened to supply an inert gas into the process chamber 201 via each of the nozzles 249a to 249c. At this time, a degree of valve opening of the APC valve 244 is set to a substantially fully opened state. However, at this time, the valve 243a may be kept closed.

Processing conditions when supplying the first processing gas in step a1 are exemplified as follows:
Processing temperature: 250 to 900 degrees C, specifically, 650 to 850 degrees C;
Processing pressure: 1 to 2,666 Pa, specifically, 1 to 1,333 Pa;
Filling pressure of first processing gas: 60 to 1,500 Torr, specifically, 200 to 1,200 Torr
Supply amount of first processing gas: 50 to 3,000 cc, specifically, 100 to 2,000 cc
Supply time of first processing gas: 0.1 to 20 seconds, specifically, 0.5 to 5 seconds
Supply flow rate of inert gas (for each gas supply pipe): 0 to 20 slm

In the present disclosure, notation of a numerical range such as "250 to 900 degrees C" means that a lower limit value and an upper limit value are included in the range. Therefore, for example, "250 to 900 degrees C" means "250 degrees C or higher and 900 degrees C or lower." The same applies to other numerical ranges. In the present disclosure, the processing temperature means the temperature of the wafer 200 or the internal temperature of the process chamber 201, and the processing pressure means the internal pressure of the process chamber 201. Further, the processing time means a time during which a process is continued. Further, when 0 slm is included in the supply flow rate, 0 slm means a case where no substance (gas) is supplied. The same applies to the following description.

By supplying the first processing gas containing a specified element (i.e., the precursor gas containing a specified element) to the wafer 200 under the above-described processing conditions, the first processing gas may be adsorbed on the surface of the wafer 200, thereby forming a first layer containing the specified element.

When the predetermined element is silicon (Si), the first processing gas may be a silane-based gas. The silane-based gas may be, for example, a gas containing Si and a halogen, i.e., a halosilane-based gas. As the halogen, at least one selected from the group of chlorine (Cl), fluorine (F), bromine (Br), and iodine (I) may be used.

The first processing gas may be a chlorosilane-based gas not containing a bond between Si atoms (i.e., a bond between predetermined elements) in one molecule, such as a tetrachlorosilane (SiCl₄) gas, a monochlorosilane (SiH₃Cl) gas, a dichlorosilane (SiH₂Cl₂) gas, a trichlorosilane (SiHCl₃) gas, or the like. As the first processing gas, in addition to the chlorosilane-based gas, it may be possible to use a fluorosilane-based gas such as a tetrafluorosilane (SiF₄) gas, a difluorosilane (SiH₂F₂) gas, or the like, a bromosilane-based gas such as a tetrabromosilane (SiBr₄) gas, a dibromosilane (SiH₂Br₂) gas, or the like, or an iodosilane-based gas such as a tetraiodosilane (SiI₄) gas, a diiodosilane (SiH₂I₂) gas, or the like, which does not contain a bond between Si atoms (i.e., a bond between predetermined elements) in one molecule.

Further, the first processing gas may be a chlorosilane-based gas containing a bond between Si atoms (i.e., a bond between predetermined elements) in one molecule, such as a hexachlorodisilane (Si₂Cl₆) gas, an octachlorotrisilane (Si₃Cl₈) gas, a monochlorodisilane (Si₂H₅Cl) gas, a dichlorodisilane (Si₂H₄Cl₂) gas, a trichlorodisilane (Si₂H₃Cl₃) gas, a tetrachlorodisilane (Si₂H₂Cl₄) gas, a monochlorotrisilane (SisHsCl) gas, a dichlorotrisilane (Si₃H₄Cl₂) gas, or the like.

As the first processing gas, in addition to these gases, it may be possible to use, for example, a gas containing Si and an amino group in one molecule, i.e., an aminosilane gas. The amino group is a monovalent functional group obtained by removing hydrogen (H) from ammonia, primary amine, or secondary amine, and may be represented as -NH₂, -NHR, or -NR₂. R represents an alkyl group, and the two R's in -NR₂ may be the same or different.

The first processing gas may be, for example, an aminosilane gas such as a tetrakis(dimethylamino)silane (Si[N(CH₃)₂]₄) gas, a tris(dimethylamino)silane (Si[N(CH₃)₂]₃H) gas, a bis(diethylamino)silane (Si[N(C₂H₅)₂]₂H₂) gas, a bis(tertiary-butylamino)silane (SiH₂[NH(C₄H₉)]₂) gas, a (diisopropylamino)silane (SiH₃[N(C₃H₇)₂]) gas, or the like.

As the first processing gas, one or more of these gases may be used. The same applies to step a3 to be described below.

The inert gas may be a nitrogen (N₂) gas, or a rare gas such as an argon (Ar) gas, a helium (He) gas, a neon (Ne) gas, a xenon (Xe) gas, or the like. One or more of these gases may be used as the inert gas. The same applies to each step to be described below.

### (ii) Step a2

After forming the first layer on the surface of the wafer 200, the valves 243a and 242a are closed to stop the supply of the first processing gas into the process chamber 201. Then, the valves 243e to 243g are opened to supply an inert gas into the process chamber 201 via the nozzles 249a to 249c. The inert gas supplied from the nozzles 249a to 249c acts as a purge gas, thereby purging the space in which the wafers 200 exist, i.e., the process chamber 201, which is a space (processing space) in which the wafers 200 are processed (purging). Then, the valves 243e to 243g are closed to stop the supply of the inert gas into the process chamber 201. Then, the inside of the process chamber 201 is vacuum-exhausted to remove gaseous substances remaining in the process chamber 201 from the inside of the process chamber 201.

As used herein, the term "purging" means removing an intermediate of the first processing gas, an intermediate of the second processing gas, and other by-products present in the process chamber 201 by supplying an inert gas into the process chamber 201. The term "vacuum exhaust" means removing an intermediate of the first processing gas, an intermediate of the second processing gas, and the like in the process chamber 201 without supplying an inert gas into the process chamber 201. Further, the expression "without supplying an inert gas" in the "vacuum exhaust" means that no purge gas is supplied. A carrier gas or a minute amount of inert gas may be supplied. Further, the expression "an intermediate of the first processing gas and an intermediate of the second processing gas" means substances obtained by mainly thermally decomposing the first processing gas and the second processing gas in the process chamber 201.

During the execution of step a2, the valve 242b is closed, and the valve 243b is opened to allow the first processing gas to flow through the gas supply pipe 232b. A flow rate of the first processing gas is regulated by the MFC 241b. The first processing gas is supplied into the second storage 240b. As a result, the second storage 240b is filled with the first processing gas at a pressure increased to a filling pressure (tank charging). When the second storage 240b is filled with a predetermined amount of the first processing gas, the valve 243b is closed to maintain the state in which the second storage 240b is filled with the first processing gas. The tank charging may be performed during the execution of step a1 or nearly simultaneously with the stop of the discharging of the first processing gas from the first storage 240a in step a1.

### (iii) Step a3

In this step, a first processing gas is supplied to the wafer 200 accommodated in the process chamber 201.

Specifically, the valve 242b is opened to allow the high-pressure first processing gas filled in the second storage 240b to flow through the decompressed process chamber 201 at a time. This causes the first processing gas to be supplied to the wafers 200 at a time (second flush supply of the first processing gas). At this time, the valve 243a is kept opened. Further, at this time, the valves 243e to 243g may be opened to supply an inert gas into the process chamber 201 via each of the nozzles 249a to 249c.

Processing conditions when supplying the first processing gas in this step (step a3) may be the same as the processing conditions when supplying the first processing gas in step a1. However, the processing conditions for step a1 and the processing conditions for this step may be made different to regulate a distribution of a film thickness in the plane of the wafer 200.

By supplying the first processing gas to the wafer 200 under the above-mentioned process conditions, the first processing gas may be adsorbed on the surface of the wafer 200 on which the first layer is formed, and a second layer containing the above-mentioned predetermined element may be further formed. The second layer is mainly formed in an area on the surface of the wafer 200 where the first layer is not formed (e.g., an adsorption site on the surface of the wafer 200, etc.). However, the second layer may be formed on the first layer. Although the first layer and the second layer containing the predetermined element are described separately herein, the first layer and the second layer together may be regarded as one layer containing the predetermined element (a layer containing a predetermined element).

After the second layer is formed on the surface of the wafer 200, the valves 243b and 242b are closed to stop the supply of the first processing gas into the process chamber 201. Then, the process chamber 201 is purged by the same processing procedure and processing conditions as in the purging in step a2. Thereafter, the inside of the process chamber 201 is vacuum-exhausted by the same processing procedure and processing conditions as in the vacuum exhaust in step a2.

### [Step B]

After step A is completed, a second processing gas is supplied to the wafers 200 accommodated in the process chamber 201.

Specifically, the valve 243c is opened to allow the second processing gas to flow through the gas supply pipe 232c. A flow rate of the second processing gas is regulated by the MFC 241c. The second processing gas is supplied into the process chamber 201 via the nozzle 249c and exhausted from via exhaust port 231a. At this time, the second processing gas is supplied to the wafers 200 (supply of second processing gas). At this time, the valves 243e to 243g may be opened to supply an inert gas into the process chamber 201 via each of the nozzles 249a to 249c. At this time, a degree of valve opening of the APC valve 244 is decreased from the fully opened state. Specifically, the degree of valve opening of the APC valve 244 is regulated to be a degree of valve opening which is in a state between a fully opened state and a fully closed state such that an internal pressure of the process chamber 201 becomes a predetermined process pressure.

Processing conditions when supplying the second processing gas in this step are exemplified as follows:
Processing temperature: 250 to 900 degrees C, specifically, 650 to 850 degrees C;
Processing pressure: 10 to 10,000 Pa, specifically, 20 to 5,000 Pa;
Supply flow rate of second processing gas: 0.001 to 20 slm, specifically, 1 to 10 slm;
Supply time of second processing gas: 1 to 120 seconds, specifically, 1 to 60 seconds; and
Supply flow rate of inert gas (for each gas supply pipe): 0 to 20 slm.

By supplying the second processing gas to the wafer 200 under the above-mentioned processing conditions, at least a portion of the first layer and the second layer formed on the wafer 200 is modified by reacting with the second processing gas. As a result, a third layer, which is a modified layer of the first layer and the second layer, is formed on the wafer 200. In other words, the second processing gas is a reaction gas that reacts with the first layer and the second layer to modify the same into the third layer.

The second processing gas may be, for example, a nitrogen (N)- and hydrogen (H)-containing gas, which is a nitriding gas. The N- and H-containing gas may be both a N-containing gas and a H-containing gas. The N- and H-containing gas may contain a N-H bond.

The second processing gas may be, for example, a hydrogen nitride gas such as an ammonia (NH₃) gas, a diazene (N₂H₂) gas, a hydrazine (N₂H₄) gas, a N₃H₈ gas, or the like.

As the second processing gas, in addition to these gases, it may be possible to use, for example, a N-, carbon (C)- and H-containing gas. The N-, C- and H-containing gas may be, for example, an amine-based gas or an organic hydrazine-based gas. The N-, C- and H- containing gas may be, for example, a N-containing gas, a C-containing gas, a H-containing gas, or a N- and C-containing gas.

The second processing may be, for example, an ethylamine-based gas such as a monoethylamine (C₂H₅NH₂) gas, a diethylamine ((C₂H₅)₂NH) gas, a triethylamine ((C₂H₅)₃N) gas or the like, a methylamine-based gas such as a monomethylamine (CH₃NH₂) gas, a dimethylamine ((CH₃)₂NH) gas, a trimethylamine ((CH₃)₃N) gas or the like, an organic hydrazine-based gas such as a monomethylhydrazine ((CH₃)HN₂H₂) gas, a dimethylhydrazine ((CH₃)₂N₂H₂) gas, a trimethylhydrazine ((CH₃)₂N₂(CH₃)H) gas or the like, and so forth.

As the second processing gas, one or more of these gases may be used.

After the third layer is formed on the surface of the wafer 200, the valve 243c is closed to stop the supply of the second processing gas into the process chamber 201. Then, the process chamber 201 is purged by the same processing procedure and processing conditions as in the purging in step a2. Thereafter, the inside of the process chamber 201 is vacuum-exhausted by the same processing procedure and processing conditions as in the vacuum exhaust in step a2.

### [Performing Predetermined Number of Times]

By performing a first cycle n times (where n is an integer of 1 or 2 or more), the first cycle including performing the above-mentioned steps A and B asynchronously, i.e., without synchronization in this order, a film may be formed on the surface of the wafer 200. That is, the first cycle according to the embodiments of the present disclosure is a cycle including steps A and B. From another viewpoint, in the embodiments, steps A and B are alternately performed n times. When the predetermined element contained in the first processing gas is, for example, Si, a Si-containing film, for example, a silicon nitride film (SiN film), may be formed on the surface of the wafer 200. The above-described first cycle may be performed multiple times. That is, a thickness of the third layer formed per cycle may be set to be smaller than a desired film thickness, and the above-mentioned cycle may be performed multiple times until a thickness of a film (e.g., a SiN film) formed by stacking the third layer reaches the desired thickness. At this time, in step A, an amount of the first processing gas pre-filled in the first storage 240a and the second storage 240b may be set to be a constant amount for each cycle. In the first cycle on and after the second time, the first storage 240a may be filled with the first processing gas in step a1 in parallel with the supply of the second processing gas in step B of the previous cycle.

### (After-Purge and Returning to Atmospheric Pressure)

After the film with the desired thickness is formed on the wafer 200, an inert gas as a purge gas is supplied into the process chamber 201 via each of the nozzles 249a to 249c and is exhausted via the exhaust port 231a. Thus, the inside of the process chamber 201 is purged such that gases, reaction by-products, and the like remaining in the process chamber 201 are removed from the inside of the process chamber 201 (after-purge). Thereafter, an internal atmosphere of the process chamber 201 is replaced with an inert gas (replacement of inert gas) and the internal pressure of the process chamber 201 is returned to the atmospheric pressure (returning to atmospheric pressure).

### (Boat Unloading and Wafer Discharging)

Thereafter, the seal cap 219 is moved down by the boat elevator 115 to open the lower end of the manifold 209. Then, the processed wafers 200 supported by the boat 217 are unloaded from the lower end of the manifold 209 to the outside of the reaction tube 203 (boat unloading). After the boat is unloaded, the shutter 219s is moved and the lower end opening of the manifold 209 is sealed by the shutter 219s (shutter closing). The processed wafers 200 are unloaded from the reaction tube 203 and are then discharged from the boat 217 (wafer discharging).

### (3) Effects of the Embodiments

According to the embodiments of the present disclosure, one or more of the following effects may be obtained.
(a) In steps a1 and a3 the first storage 240a and the second storage 240b is filled with the first processing gas in advance, respectively. Then the first processing gas is compressed, and supplied into the process chamber 201. That is, the compressed first processing gas is supplied (flash-supplied) to the wafer 200 in the decompressed process chamber 201 at once in a short time. By increasing a flow velocity when supplying the first processing gas into the process chamber 201 in this manner, it is possible to improve a step coverage of the film formed in the recess of the wafer 200.

In steps a1 and a3, the first processing gas is flush-supplied via the gas supply holes 250a and the gas supply holes 250b into the process chamber 201. By performing the flush supply by using the plurality of gas supply holes (the gas supply holes 250a and the gas supply holes 250b) formed at different positions in a direction along the outer periphery of the wafer 200 (circumferential direction) in this way, it is possible to improve a controllability of the film thickness distribution in the substrate plane.

In step A, the first processing gas is sequentially flush-supplied into the process chamber 201 by using different storages (the first storage 240a and the second storage 240b). By flush-supplying the first processing gas sequentially in this manner, it is possible to shorten a time for performing flush supply once. By shortening the time for performing flush supply once, it is possible to further reduce retention of the first processing gas and by-products in the process chamber 201, and it is possible to utilize an initial period in which the flow velocity of the flush supply is high. By shortening a retention time of the first processing gas in the process chamber 201 in this manner, it is possible to further suppress intermediates of the first processing gas and by-products from being supplied to the wafer 200. This makes it possible to further enhance the step coverage, improve the film thickness distribution in the substrate plane, and reduce particles.

In step A, the first processing gas is sequentially flush-supplied into the process chamber 201 by using different storages (the first storage 240a and second storage 240b). Thus, even in a case where the number of flush supplies is increased, it is possible to minimize a decrease in throughput caused by a time for filling the storages with the first processing gas (tank charging time). This makes it possible to achieve both improved step coverage and improved throughput.

In step A, the inside of the process chamber 201 is exhausted in step a2 executed between the flush supply in step a1 and the flush supply in step a3. Thus, it is possible to promote discharge of the first processing gas and by-products remaining in the process chamber 201. This makes it possible to further enhance the step coverage, improve the film thickness distribution in the substrate plane, and reduce particles.

In steps a1 and a3, the first processing gas is flush-supplied into the process chamber 201 by using the storages (the first storage 240a and the second storage 240b) that are individually installed for different gas supply holes (the gas supply holes 250a and 250b). This makes it easy to regulate the supply amount and flow velocity of the first processing gas for each nozzle, and makes it possible to further improve the controllability of the film thickness distribution in the substrate plane.

(b) In both steps a1 and a3, the first processing gas is supplied to the wafer 200 while the inside of the process chamber 201 is being exhausted. Thus, it is possible to continuously exhaust intermediates of the first processing gas and by-products generated by the first processing from the inside of the process chamber 201. This makes it possible to improve the step coverage and the film thickness uniformity in the substrate plane.

(c) In steps a1 and a3, a degree of valve opening of the APC valve 244 while the inside of the process chamber 201 is being exhausted is set to be larger than a degree of valve opening of the APC valve 244 while the inside of the process chamber 201 is being exhausted in step B. This makes it possible to increase an exhaust speed compared to when the second processing gas, which is a reaction gas, is supplied, and to efficiently exhaust intermediates of the first processing gas as a precursor gas and by-products from the inside of the process chamber 201.

(d) In step a2, the inside of the process chamber 201 is exhausted while the inert gas is being supplied into the process chamber 201. This makes it possible to more efficiently exhaust gases and by-products remaining in the process chamber 201.

(e) The first storage 240a and the gas supply holes 250a are connected via the gas supply pipe 232a, and the second storage 240b and the gas supply holes 250b are connected via the gas supply pipe 232b as a second pipe independent from the gas supply pipe 232a without any common section. According to this configuration, another valve may not be installed to switch between the gas supply holes 250a and the gas supply holes 250b at the downstream side of the valve 242a on an output side of the first storage 240a. This makes it possible to avoid a decrease in conductance (a decrease in flow velocity) due to an intermediate valve on the way during flush supply. Further, it is possible to prevent the first processing gas or the like from staying in the pipe at the upstream side of the valve on the way and to prevent the staying first processing gas or the like from affecting the substrate processing.

(f) The gas supply holes 250a and 250b are configured to supply the first processing gas from the outer periphery of the wafer 200 toward the plane of the wafer 200, and at least one selected from the group of: the gas supply holes 250a; and the gas supply holes 250b are configured to supply the first processing gas in a direction different from the direction facing the center of the wafer 200. Thus, the film thickness distribution in the substrate plane may be easily controlled by regulating gas discharge directions of the gas supply holes 250a and 250b, respectively.

(g) The above-described effects may be obtained similarly even when the above-described various first processing gases, the above-described various second processing gases, and the above-described various inert gases are used. However, the above-described effects may be remarkable when a gas containing a bond between predetermined elements is used as the first processing gas, i.e., when a gas that is easily decomposed by thermal energy or the like after being supplied into the process chamber 201 is used. In addition, the above-described effects may be remarkable when the first processing gas (precursor gas) whose decomposition in the process chamber 201 particularly affects the step coverage and the film thickness distribution in the substrate plane is supplied.

### (4) Modification

The processing sequence in the embodiments of the present disclosure may be modified as shown in the following modifications. These modifications may be combined arbitrarily. Unless otherwise specified, the processing procedure and processing conditions in each step of each modification may be the same as the processing procedure and processing conditions in each step of the above-described processing sequence.

### (First Modification)

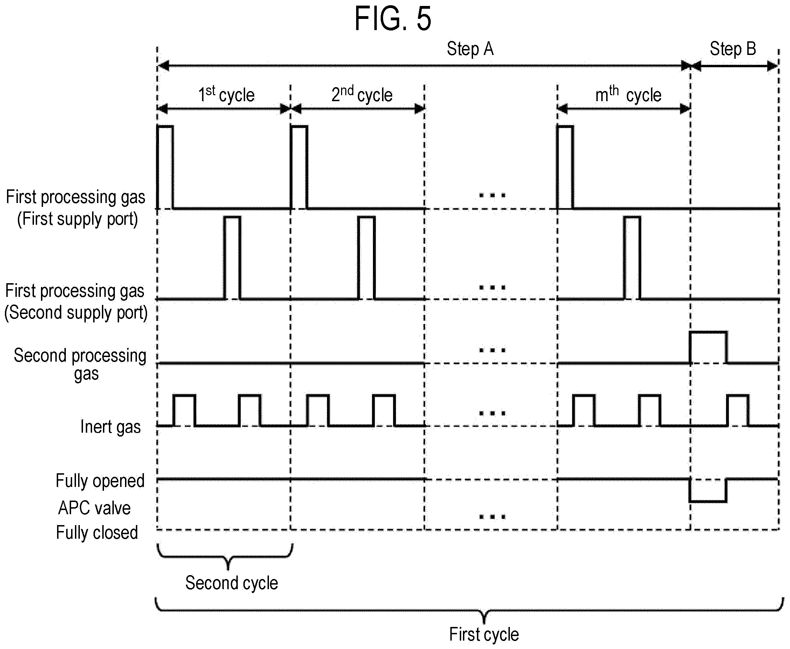

As in FIG. 5 and the processing sequence shown below, in step A, a second cycle may be performed a predetermined number of times (m times where m is an integer of 2 or more), the second cycle including sequentially performing:
(a-1) step a1 (first flush step) of opening the first storage 240a filled with the first processing gas and supplying the first processing gas discharged from the first storage 240a to the wafer 200 via the gas supply holes 250a; and
(a-3) step a3 (second flush step) of opening the second storage 240b filled with the first processing gas and supplying the first processing gas discharged from the second storage 240b to the wafer 200 via the gas supply holes 250b different from the gas supply holes 250a.

That is, in step A according to this modification, step a1 may be further performed after step a3 (step a1, step a3, and step a1 may be performed sequentially). In other words, in step A according to this modification, step a1, step a3, and step a1' may be performed sequentially. As used herein, the expression "step a1‴ means step a1 performed after step a3 in step A.

In this modification, in step A, after performing step a3 and before performing step a1 (i.e., step a1') for the second time, the inside of the process chamber 201 may be exhausted in a state in which the supply of the first processing gas to the wafer 200 is stopped. Further, in step A, after performing step a1 and before performing step a3, the inside of the process chamber 201 may be exhausted in a state in which the supply of the first processing gas to the wafer 200 is stopped. That is, in step A, the second cycle of performing step a1, exhaust, and step a3 sequentially may be performed two or more times. Further, in step B, the inside of the process chamber 201 may be exhausted after supplying the second processing gas. f (first processing gas → exhaust → first processing gas → exhaust) × m → (second processing gas -> exhaust)} × n

In this modification, the same effects as those of the above-described embodiments may be obtained. In this modification, by supplying the first processing gas from the first storage 240a at least two times, it is possible to supply a sufficient amount of the first processing gas to the wafer 200. By performing step a1 again, it is possible to supply a sufficient amount of the first processing gas to the wafer 200. Further, since the exhaust step is performed in a state in which the supply of the first processing gas to the wafer 200 is stopped, it is possible to promote the discharge of the first processing gas and by-products remaining in the process chamber 201, and to obtain effects such as further improvement of the step coverage, improvement of the substrate in-plane distribution, and particle reduction. In addition, since the second cycle is performed two or more times, a sufficient amount of the first processing gas may be supplied to the wafer 200. This is particularly suitable for a case where a short-time flush supply is performed.

### (Second Modification)

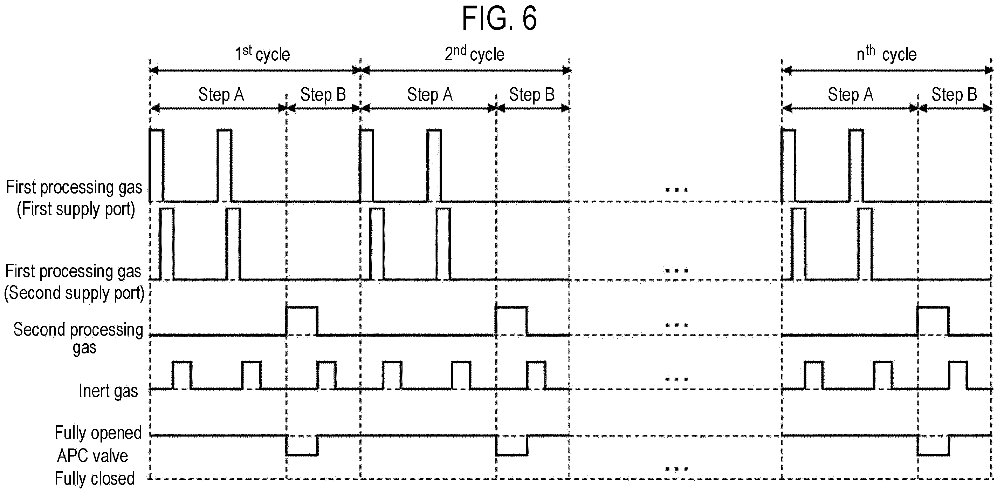

As shown in FIG. 6, in step A, the second cycle of performing step a1 and step a3 sequentially may be performed two or more times, and execution periods of step a1 and step a3 may overlap at least partially. FIG. 6 illustrates a case in which the second cycle is performed two or more times. In this modification, as shown in FIG. 6, in step A, after performing a p-th step a3 and before performing a (p+1)-th step a1, the inside of the process chamber 201 may be exhausted in a state in which the supply of the first processing gas to the wafer 200 is stopped (where p is an integer of 1 or 2 or more).

In this modification, the same effects as those of the above-described embodiments may be obtained. In this modification, by continuously performing the flush supply in an overlapping manner, a state of high flow velocity may be maintained for a long time. Further, after performing step a3, by performing the exhaust step in a state in which the supply of the first processing gas to the wafer 200 is stopped, it is possible to promote the discharge of the first processing gas and by-products remaining in the process chamber 201, and to obtain effects such as further improvement of the step coverage, improvement of the substrate in-plane distribution, and particle reduction.

### (Third Modification)

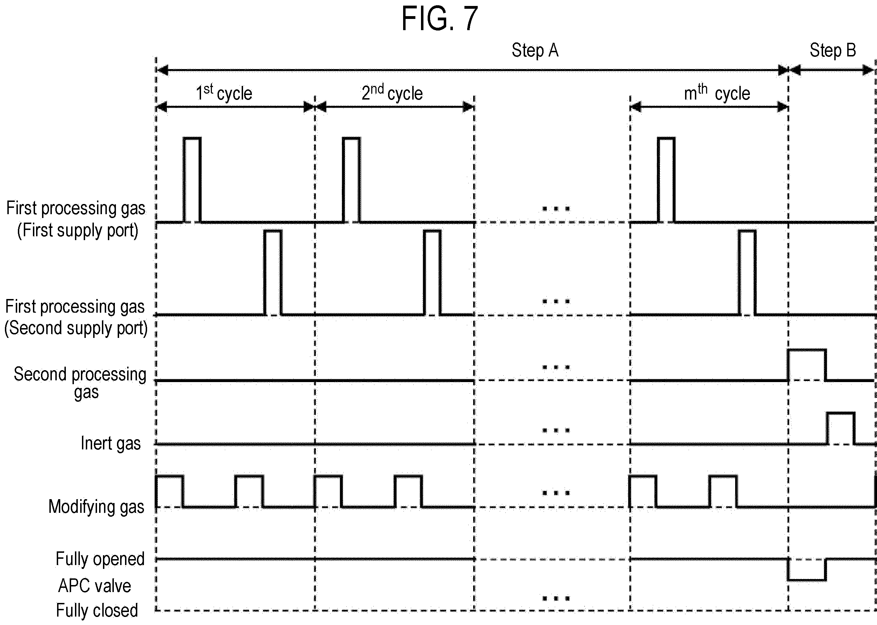

As shown in FIG. 7, in step a2, a modifying gas that inhibits adsorption of the first processing gas on the surface of the wafer 200 may be supplied to the wafer 200.

The modifying gas may be a gas containing at least one selected from the group of Cl, F, Br, and I as a halogen element. The modifying gas may be, for example, a gas composed of a halogen element such as a fluorine (F₂) gas, a chlorine (Cl₂) gas, a bromine (Br₂) gas, an iodine (I₂) gas or the like, an interhalogen compound gas such as a chlorine fluoride (ClF₃) gas, a bromine chloride (BrCl) gas, an iodine chloride (ICl) gas, an iodine fluoride (IF₅) gas, a bromine fluoride (BrF₃) gas, an iodine bromide (IBr) gas or the like, a hydrogen halide compound gas such as a hydrogen chloride (HCl) gas, a hydrogen fluoride (HF) gas, a hydrogen bromide (HBr) gas, a hydrogen iodide (HI) gas or the like, or a combination of these gases. Further, radicals (Cl*, F*, Br*, I*, etc.) containing a halogen element generated by activating these gases by plasma excitation or the like may be used. As the modifying gas, one or more of these gases may be used.

In step a2 or the like, the modifying gas is supplied to the wafer 200 in the process chamber 201 by a modifying gas supply system.

Processing conditions when supplying the modifying gas in this step are exemplified as follows:
Processing temperature: 250 to 900 degrees C, specifically, 650 to 850 degrees C;
Processing pressure: 1 to 10,000 Pa, specifically, 10 to 1,333 Pa;
Supply flow rate of modifying gas: 0.01 to 3 slm, specifically, 0.1 to 1 slm;
Supply time of modifying gas: 1 to 120 seconds, specifically, 5 to 30 seconds
Supply flow rate of inert gas (for each gas supply pipe): 0 to 20 slm.

By supplying the modifying gas to the wafer 200 under the above-described processing conditions, the modifying gas may be adsorbed to an adsorption site present on the surface of the wafer 200 with the recess. By supplying the modifying gas to the wafer 200 under the above-described processing conditions, adsorption of the first processing gas supplied in step A on the wafer 200 is inhibited. By controlling the adsorption of the first processing gas on the surface in the recess by supplying the modifying gas, it is possible to improve the step coverage of the film formed in the recess. For example, by causing the modifying gas selectively adsorbed on an upper portion of a sidewall surface in the recess, the first processing gas may be preferentially adsorbed on a lower portion and a bottom portion of the sidewall surface in the recess, thereby realizing bottom-up film formation.

In this modification, the same effects as those of the above-described embodiments may be obtained. In this modification, the step coverage of the film may be further improved. Further, the throughput may be improved by performing the supply of the modifying gas during the exhaust step in parallel.

Further, in this modification, the example is described in which the modifying gas is supplied to the wafer 200 during step a2. However, the modifying gas may be supplied during a period other than step a2. For example, the modifying gas may also be supplied during a period of at least a part of steps a1 and a3 in addition to the period of step a2. In this modification, the same effects as those of the above-described embodiments may be obtained. In this modification, even in a case where the period of step a2 is short, it is possible to secure a sufficient time to supply the modifying gas.

### <Other Embodiments of Present Disclosure>

The embodiments of the present disclosure are specifically described above. However, the present disclosure is not limited to the above-described embodiments, and various modifications may be made without departing from the spirit of the present disclosure.

Although not specifically described in the above-described embodiments, the supply amount of the first processing gas to the wafer 200 in step a1 of the second cycle on a (k+1)-th time may be different from the supply amount of the first processing gas in step a1 of the second cycle on a k-th time. As used herein, k is an integer of 1 or 2 or more. The supply amount of the first processing gas may be controlled by regulating the supply time (i.e., a storage amount) of the first processing gas for the storage or regulating an opening time of the first storage 240a. In these embodiments, the same effects as those of the above-described embodiments may be obtained. Furthermore, in these embodiments, the film thickness distribution in the substrate plane may be controlled by regulating the supply amount of the first processing gas. In particular, the film thickness distribution in the substrate plane may be regulated from a concave distribution to a convex distribution by regulating the supply amount of the first processing gas per cycle to be decreased.

Although not specifically described in the above-described embodiments, the execution time of at least one selected from the group of steps a1 and a3 may be set so that the film thickness distribution in the plane of the wafer 200 becomes a desired distribution. The execution time of at least one selected from the group of steps a1 and a3 may be regulated to regulate the film thickness distribution in the plane of the wafer 200. In these embodiments, the same effects as those of the above-described embodiments may be obtained. Further, in these embodiments, the film thickness distribution in the plane of the wafer 200 may be controlled by regulating the supply time of the first processing gas. In particular, the film thickness distribution in the substrate plane may be regulated toward a convex distribution by regulating the supply time of the first processing gas per cycle to be shortened, and can be regulated toward a concave distribution by regulating the supply time of the first processing gas per cycle to be lengthened.

Although not specifically described in the above-described embodiments, in step a1, the discharge of the first processing gas from the first storage 240a may be stopped while the first processing gas remains in the first storage 240a. Similarly, in step a3, the discharge of the first processing gas from the second storage 240b may be stopped while the first processing gas remains in the second storage 240b. In these embodiments, the same effects as those of the above-described embodiments may be obtained. Further, in these embodiments, by stopping the discharge of the gas while the gas pressures in the first storage 240a and the second storage 240b are high, flush supply may be performed during the period in which the flow velocity of the first processing gas is high.

In the above-mentioned embodiments, the case is described where in the first cycle on and after the second time, the first storage 240a is filled with the first processing gas (tank charging) in step A in parallel with step B in the previous cycle. However, the present disclosure is not limited thereto. For example, in the first cycle on and after the second time, the first storage 240a may be filled with the first processing gas during the execution period of at least one selected from the group of steps a2 and a3 (i.e., before the start of step B) after the discharge of the first processing gas is stopped in step a1 of the previous cycle. In these embodiments, the same effects as those of the above-described embodiments may be obtained. Furthermore, in these embodiments, the cycle time may be further shortened and the throughput may be further improved. Further, the tank charging may be performed without discharging the first processing gas in the first storage 240a. This may shorten the charging time. Further, by not discharging the residual gas, it is possible to reduce consumption of the first processing gas.

Although not specifically described in the above-described embodiments, the execution time of step a2 may be set to be longer than the execution time of step a1. In these embodiments, the same effects as those of the above-described embodiments may be obtained. Further, in these embodiments, it is possible to sufficiently secure a time for the exhaust step in the process chamber 201, and to further promote the discharge of the first processing gas and by-products remaining in the process chamber 201.

In the above-described embodiments, the case is described where purging and vacuum exhaust are performed sequentially when exhausting the inside of the process chamber 201 after the supply of the first processing gas in step A and after the supply of the second processing gas in step B. However, the present disclosure is not limited to the above-described embodiments. For example, in at least one selected from the group of the exhaust step after the supply of the first processing gas in step A and the exhaust step after the supply of the second processing gas in step B, the vacuum exhaust may be performed without performing the purging. Specifically, for example, in the exhaust step after the supply of the first processing gas in step A, the vacuum exhaust may be performed without performing the purging. In these embodiments, the same effects as those of the above-described embodiments may be obtained.

In the above-described embodiments, the example is described in which the first processing gas is, for example, the precursor gas containing Si as the predetermined element. However, the present disclosure is not limited thereto. The present disclosure may be applied to, for example, a case where a first processing gas containing a metal element such as aluminum (Al), titanium (Ti), hafnium (Hf), zirconium (Zr), tantalum (Ta), molybdenum (Mo), or tungsten (W) as the predetermined element is used, and a film containing a metal element, such as an aluminum nitride film (AlN film), a titanium nitride film (TiN film), a hafnium nitride film (HfN film), a zirconium nitride film (ZrN film), a tantalum nitride film (TaN film), a molybdenum nitride film (MoN film), a tungsten nitride film (WN film), an aluminum oxide film (AlO film), a titanium oxide film (TiO film), a hafnium oxide film (HfO film), a zirconium oxide film (ZrO film), a tantalum oxide film (TaO film), a molybdenum oxide film (MoO film), a tungsten oxide film (WO film), a titanium oxynitride film (TiON film), a titanium aluminum carbonitride film (TiAlCN film), a titanium aluminum carbide film (TiAlC film), a titanium carbonitride film (TiCN film) or the like is formed on the wafer 200 by the above-described processing sequence. In these embodiments, the same effects as those of the above-described embodiments may be obtained.

In the above-described embodiments, the example is described in which the second processing gas is, for example, the N- and H-containing gas as a reaction gas (nitriding gas) containing N. However, the present disclosure is not limited thereto. For example, the reaction gas may be a carbon (C)-containing gas such as an ethylene (C₂H₄) gas, an acetylene (C₂H₂) gas, a propylene (C₃H₆) gas or the like, a boron (B)-containing gas such as a diborane (B₂H₆) gas, a trichloroborane (BCl₃) gas or the like, or an oxygen (O₂)-containing gas (oxidizing gas) such as an oxygen (O₂) gas, an ozone (O₃) gas, a plasma-excited O₂ gas (O₂*), O₂ gas + hydrogen (H₂) gas, a water vapor (H₂O gas), a hydrogen peroxide (H₂O₂) gas, a nitrous oxide (N₂O) gas, a nitric oxide (NO) gas, a nitrogen dioxide (NO₂) gas, a carbon monoxide (CO) gas, carbon dioxide (CO₂) gas or the like, and so forth. Further, in the present disclosure, the description of two gases in combination, such as "O₂ gas + H₂ gas," means a mixed gas of O₂ gas and H₂ gas. When supplying the mixed gas, two gases may be mixed (pre-mixed) in the supply pipe and then supplied into the process chamber 201, or two gases may be separately supplied into the process chamber 201 via different supply pipes and then mixed (post-mixed) in the process chamber 201. One or more of these gases may be used as the second processing gas. In these embodiments, the same effects as those of the above-described embodiments may be obtained.

In the above-described embodiments, the case is described where the SiN film is formed on the wafer 200 in the substrate processing. However, the present disclosure is not limited thereto. The present disclosure may be applied to a case of forming a film containing Si, such as a silicon carbonitride film (SiCN film), a silicon oxynitride film (SiON film), a silicon oxycarbide film (SiOC film), a silicon oxycarbonitride film (SiOCN film), a silicon borocarbonitride film (SiBCN film), a silicon boronitride film (SiBN film), a silicon oxide film (SiO film) or the like, as well as the case of forming the SiN film. In these embodiments, the same effects as those of the above-described embodiments may be obtained.

In the above-described embodiments, the case is described where the precursor gas is used as the first processing gas, and the reaction gas is used as the second processing gas. However, the present disclosure is not limited thereto. For example, the reaction gas may be supplied as the first processing gas from the first supply port and the second supply port, and the precursor gas may be supplied as the second processing gas from the third supply port. In these embodiments, at least a portion of the same effects as those of the above-described embodiments may be obtained.

Recipes used in each process may be provided individually according to the processing contents and may be recorded and stored in the memory 121c via a telecommunication line or the external memory 123. Moreover, at the beginning of each process, the CPU 121a may properly select an appropriate recipe from the recipes recorded and stored in the memory 121c according to the processing contents. Thus, it is possible for a single substrate processing apparatus to form films of various kinds, composition ratios, qualities, and thicknesses with enhanced reproducibility. Further, it is possible to reduce an operator's burden and to quickly start each process while avoiding an operation error.

The recipes described above are not limited to newly-provided ones but may be provided, for example, by modifying existing recipes that are already installed in the substrate processing apparatus. When the recipes are modified, the modified recipes may be installed in the substrate processing apparatus via a telecommunication line or a recording medium storing the recipes. In addition, the existing recipes already installed in the existing substrate processing apparatus may be directly modified by operating the input/output device 122 of the substrate processing apparatus.

Examples in which a film is formed by using a batch-type substrate processing apparatus configured to process a plurality of substrates at a time are described in the above-described embodiments. The present disclosure is not limited to the above-described embodiments, but may be suitably applied, for example, to a case where a film is formed by using a single-wafer type substrate processing apparatus configured to process a single substrate or several substrates at a time. In addition, examples in which a film is formed by using a substrate processing apparatus provided with a hot-wall-type process furnace are described in the above-described embodiments. The present disclosure is not limited to the above-described embodiments, but may be suitably applied to a case where a film is formed by using a substrate processing apparatus provided with a cold-wall-type process furnace. In the above-described embodiments, the case where the gas is activated by heat are described. However, the present disclosure is not limited thereto. For example, the present disclosure may be suitably applied to a case where a gas is activated by plasma generated inside or outside the process chamber 201, or a case where a gas is activated by irradiating the gas with electromagnetic waves by a lamp or the like.

Even when these substrate processing apparatuses are used, each process may be performed under the same processing procedures and processing conditions as those of the above-described embodiments and modifications. The same effects as those of the above-described embodiments and modifications may be obtained.

The above-described embodiments and modifications may be used in combination as appropriate. The processing procedure and processing conditions at this time may be, for example, the same as the processing procedures and processing conditions of the above-described embodiments and modifications.

According to the present disclosure in some embodiments, it is possible to improve a step coverage of a film formed on a substrate.

While certain embodiments are described above, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
forming a film on the substrate (200) by performing a first cycle a predetermined number of times, the first cycle including performing:
(a) supplying a first processing gas to the substrate (200); and
(b) supplying a second processing gas to the substrate (200),
wherein (a) includes sequentially performing:
(a-1) opening a first storage (240a) filled with the first processing gas and supplying the first processing gas discharged from the first storage (240a) to the substrate (200) via a first supply port (250a);
(a-2) exhausting a processing space in which the substrate (200) is processed while stopping the supply of the first processing gas to the substrate (200); and
(a-3) opening a second storage (240b) filled with the first processing gas and supplying the first processing gas discharged from the second storage (240b) to the substrate (200) via a second supply port (250b) different from the first supply port (250a).

2. The method of Claim 1, wherein in (a-1) and (a-3), the first processing gas is supplied to the substrate (200) while the processing space is exhausted.

3. The method of Claim 2, wherein an opening degree of an exhaust valve (244) installed at an exhaust path (231) of the processing space while the processing space is being exhausted in (a-1) and (a-3) is set to be larger than an opening degree of the exhaust valve (244) while the processing space is being exhausted in (b).

4. The method of any one of Claims 1 to 3, wherein (a) further includes performing:
(a-1') after performing (a-3), opening the first storage (240a) filled with the first processing gas and supplying the first processing gas discharged from the first storage (240a) to the substrate (200) via the first supply port (250a).

5. The method of Claim 4, wherein (a) further includes performing:
(a-4) after performing (a-3) and before performing (a-1'), exhausting the processing space while stopping the supply of the first processing gas to the substrate (200).

6. The method of any one of Claims 1 to 3, wherein in (a), a second cycle is performed two or more times, the second cycle including sequentially performing (a-1), (a-2), and (a-3).

7. The method of Claim 6, wherein a supply amount of the first processing gas in (a-1) of the second cycle on a (k+1)-th time is different from a supply amount of the first processing gas in (a-1) of the second cycle on a k-th time.

8. The method of any one of Claims 1 to 7, wherein the film is formed by performing the first cycle two or more times.

9. The method of any one of Claims 1 to 3 and 6 to 8, wherein an execution time of (a-2) is set to be longer than an execution time of (a-1).

10. The method of any one of Claims 1 to 9, wherein the first storage (240a) and the first supply port (250a) are connected via a first pipe (232a), and the second storage (240b) and the second supply port (250b) are connected via a second pipe (232b) that is independent from the first pipe.

11. The method of any one of Claims 1 to 10, wherein the first supply port (250a) and the second supply port (250b) are configured to supply the first processing gas from a periphery of the substrate (200) toward a plane of the substrate (200), and at least one selected from the group of the first supply port (250a) and the second supply port (250b) is configured to supply the first processing gas in a direction different from a direction facing a center of the substrate (200).

12. The method of any one of Claims 1 to 11, wherein in (a-2), a modifying gas that inhibits the first processing gas from being adsorbed on the substrate (200) is supplied to the substrate (200).

13. A method of manufacturing a semiconductor device, comprising the method of Claim 1.

14. A program that causes, by a computer, a substrate processing apparatus to perform a process comprising:
forming a film on a substrate (200) by performing a first cycle a predetermined number of times, the first cycle including performing:
(a) supplying a first processing gas to the substrate (200); and
(b) supplying a second processing gas to the substrate (200),
wherein (a) includes sequentially performing:
(a-1) opening a first storage (240a) filled with the first processing gas and supplying the first processing gas discharged from the first storage (240a) to the substrate (200) via a first supply port (250a);
(a-2) exhausting a processing space in which the substrate (200) is processed while stopping the supply of the first processing gas to the substrate (200); and
(a-3) opening a second storage (240b) filled with the first processing gas and supplying the first processing gas discharged from the second storage (240b) to the substrate (200) via a second supply port (250b) different from the first supply port (250a).

15. A substrate processing apparatus, comprising:
a first gas supply system including a first storage (240a) and a first supply port (250a) configured to supply a first processing gas filled in the first storage (240a) to a substrate (200);
a second gas supply system including a second storage (240b) and a second supply port (250b) different from the first supply port (250a), the second supply port (250b) configured to supply the first processing gas filled in the second storage (240b) to the substrate (200);
a third gas supply system configured to supply a second processing gas to the substrate (200);
an exhaust system configured to exhaust a processing space in which the substrate (200) is processed; and
a controller (121) configured to be capable of controlling the first gas supply system, the second gas supply system, the third gas supply system, and the exhaust system so as to perform a process comprising:
forming a film on the substrate (200) by performing a first cycle a predetermined number of times, the first cycle including performing:
(a) supplying the first processing gas to the substrate (200); and
(b) supplying the second processing gas to the substrate (200),
wherein (a) includes sequentially performing:
(a-1) opening the first storage (240a) filled with the first processing gas and supplying the first processing gas to the substrate (200) via the first supply port (250a);
(a-2) exhausting the processing space while stopping the supply of the first processing gas to the substrate (200); and
(a-3) opening the second storage (240b) filled with the first processing gas and supplying the first processing gas to the substrate (200) via the second supply port (250b).
